Europäisches Patentamt

European Patent Office

Office européen des brevets

(11) Veröffentlichungsnummer: **0 348 697**
**A2**

(12) **EUROPÄISCHE PATENTANMELDUNG**

(21) Anmeldenummer: 89110184.2

(51) Int. Cl.⁴: **H03J 5/24**

(22) Anmeldetag: 06.06.89

---

(30) Priorität: 28.06.88 DE 3821714

(43) Veröffentlichungstag der Anmeldung:
**03.01.90 Patentblatt 90/01**

(84) Benannte Vertragsstaaten:
**DE FR GB IT SE**

(71) Anmelder: **TELEFUNKEN electronic GmbH**
**Theresienstrasse 2**
**D-7100 Heilbronn(DE)**

(72) Erfinder: **Heigl, Franz, Dipl.-Ing. (FH)**
**Frühlingstrasse 12**
**D-8079 Ochsenfeld(DE)**

(74) Vertreter: **Maute, Hans-Jürgen, Dipl.-Ing.**
**TELEFUNKEN electronic GmbH**
**Theresienstrasse 2**
**D-7100 Heilbronn(DE)**

---

(54) **Fernsehtuner.**

(57) Ein Fernsehtuner weist einen gemeinsamen Antennenanschluß (1) für zwei Frequenzbereich auf, die die Frequenzen von VHF-Band I bis einschließlich Hyperband überstreichen. Dabei ist ein für die beiden Frequenzbereiche bemessenes Vorkreisfilter (12) und eine Vorverstärkerschaltung (15) sowie zwei eigenständige Bandfilter (19,21) vorgesehen. Um bei einfachem Schaltungsaufbau und niedrigem Platzbedarf sehr gute Empfangseigenschaften und hohe Störsicherheit zu erzielen, besteht das Vorkreisfilter (12) aus einer Schwingkreisschaltung mit umschaltbaren Spulen, von der das vorselektierte Signal über einen gemeinsamen Vorverstärker (15) an eine zweistufige Umschalteinrichtung (17) geliefert wird, die gleichzeitig mit dem Vorkreisfilter (15) umgeschaltet wird. An die Umschalteinrichtung sind die getrennten Bandfilter (19,21) angeschlossen, welchen jeweils eine eigene Mischstufe (25,26) nachgeschaltet ist.

FIG.1

# Fernsehtuner

Die Erfindung betrifft einen Fernsehtuner gemäß dem Oberbegriff des ersten Anspruchs.

Bei einem bekannten Fernsehtuner dieser Art (DE-OS 35 38 921) ist an einen Antennenanschluß neben einem UHF-Tunerzweig unmittelbar ein eigenständiges Vorkreisfilter für einen niedrigen Frequenzbereich und über eine Schaltdiode ein eigenständiges Vorkreisfilter für einen hohen Frequenzbereich angeschaltet. Die beiden Frequenzbereiche überstreichen dabei die Frequenzen von zirka 50 MHz bis zirka 470 MHz, also durchgehend die Frequenzen vom niedrigen VHF-Band I bis einschließlich Hyperband. Jedem der Vorkreisfilter ist ein aktiver Vorverstärker nachgeschaltet, an deren Ausgänge je ein für den betreffenden Frequenzbereich ausgelegtes Bandfilter angeschlossen ist. Die Ausgangssignale der beiden Bandfilter sind auf eine Umschalteinrichtung geführt, deren gemeinsamer Ausgang auf eine integrierte Tunerschaltung geführt ist, die eine Misch-, Oszillator- und ZF-Verstärkerstufe umfaßt. Für den Aufbau von zwei vollkommen getrennten aktiven Vorselektionswegen ergibt sich ein relativ hoher Aufwand an Bauteilen und damit auch ein entsprechend hoher Platzbedarf.

Der Erfindung liegt die Aufgabe zugrunde, einen Tuner gemäß dem Oberbegriff des ersten Anspruchs zu schaffen, bei dem unter Ausnutzung von modernen integrierten Tunerschaltungsmitteln ein geringer Platzbedarf bei minimalem Bauteileaufwand erreicht wird und der sehr gute Empfangseigenschaften bei hoher Störsicherheit bietet.

Die Lösung dieser Aufgabe erfolgt gemäß der Erfindung durch die kennzeichnenden Merkmale des ersten Anspruchs.

Bei einem Aufbau eines Tuners gemäß der Erfindung ist für das Vorkreisfilter lediglich ein gemeinsamer frequenzbestimmender Kondensator und auch nur eine Umschaltdiode erforderlich, wobei der gemeinsame Ausgang dieser Vorkreisfilterschaltung auch nur einen Vorverstärker für beide Frequenzbereiche erfordert. Hierdurch wird der Bauteileaufwand und damit auch der Platzbedarf auf einen minimalen Wert reduziert. Dabei ist die hochfrequenzmäßige Umschaltung von der gemeinsamen Vorstufe auf die beiden getrennten Bandfilter mit geringem Aufwand ausführbar, während die ebenfalls getrennten Mischstufen die Einstellung optimaler Mischbedingungen für die beiden Frequenzbereiche ermöglichen. Hierdurch ist aber die angestrebte hohe Störsicherheit bei sehr guten Empfangseigenschaften gesichert.

Das Vorkreisfilter besteht dabei vorzugsweise aus der Serienschaltung von drei frequenzbestimmenden Spulen, zu welchen ein gemeinsamer frequenzbestimmender Kondensator parallel geschaltet ist. Dabei liegt die erste Spule an Massepotential und die dritte Spule am Eingang des Vorverstärkers, wobei parallel zur Serienschaltung aus der zweiten und der dritten Spule lediglich ein Bereichschalter liegt. Zusätzlich ist an den Verbindungspunkt zwischen der zweiten und der dritten Spule eine Anpassungsspule angeschaltet, die andererseits mit dem Antennenanschluß verbunden ist. Die erste Spule ist dabei frequenzbestimmend für den hohen Frequenzbereich, während die drei in Serie liegenden Spulen zusammen den niederen Frequenzbereich definieren. Der gemeinsame Schwingkreiskondensator ist dabei vorzugsweise veränderbar, so daß innerhalb der Frequenzbereiche eine Selektion bestimmter Kanäle ausführbar ist. Die Anschaltung des Vorverstärkers an die Bandfilter erfolgt vorzugsweise so, daß das Bandfilter für den hohen Frequenzbereich über einen Kondensator und das Bandfilter für den niedrigen Frequenzbereich über die Reihenschaltung aus einer Spule und einem Tiefpaßkondensator angeschaltet ist, wobei zwischen dem Verbindungspunkt der Spule mit dem Kondensator und Massepotential ein einziger Bandschalter liegt. Bei geöffnetem Bandschalter ist dann das Bandfilter für den hohen Frequenzbereich so weit verstimmt, daß eine Selektion praktisch nicht mehr eintritt, während das Bandfilter für den tiefen Frequenzbereich optimal über den Tiefpaß an die Vorstufe angekoppelt ist. Bei geschlossenem Bandschalter dagegen ist der Eingang des Bandfilters für den tiefen Frequenzbereich hochfrequenzmäßig kurzgeschlossen, wobei die Spule und der Kondensator einen für den hohen Frequenzbereich bemessenen Hochpaß bilden, über den das Bandfilter für den hohen Frequenzbereich an den Vorverstärker so angepaßt ist, daß es seine optimale Selektionswirkung erreicht.

Andere vorteilhafte Weiterbildungen der Erfindung sind in den übrigen Ansprüchen angegeben.

Die Erfindung ist nachfolgend anhand der Schaltungsskizzen eines Ausführungsbeispiels näher erläutert.

Es zeigt:

Figur 1 ein Blockschaltbild eines gemäß der Erfindung aufgebauten Tuners,

Figur 2 eine Schaltung der hochfrequenzmäßig wirksamen Bauteile des Vorselektionsteils,

Figur 3 eine Schaltungsanordnung zur Anschaltung von Bandfiltern an die Vorstufe und

Figur 4 die mit Gleichstromwegen ergänzte Schaltungsanordnung nach Figur 3.

Ein Fernsehtuner ist mit einem gemeinsamen Antennenanschluß 1 ausgestattet, von dem ein erster Bereichschalter 2 zu einem Tunerzweig für die Frequenzen des VHF-Bandes I bis einschließlich Hyperband und ein zweiter Bereichsschalter 3 zu einem UHF-Tunerzweig führen. Der UHF-Tunerzweig ist aus einem Vorkreisfilter 4 mit nachfolgendem Vorverstärker 5 und daran anschließendem Bandfilter 6 mit nachfolgender Mischstufe 7 gebildet, der ein eigenständiger Oszillator 8 zugeordnet ist. Die UHF-Mischstufe 7 ist mit einem Zwischenfrequenzkreis 9 gekoppelt, dem ein Zwischenfrequenzverstärker 10 mit einem Zwischenfrequenzausgang 11 nachfolgt.

An den ersten Bereichsschalter 2 ist dagegen ein Vorkreisfilter 12 angeschlossen, das auf einen niedrigen und einen direkt anschließenden höheren Frequenzbereich umschaltbar ist. Dieses für die beiden Frequenzbereiche kombinierte Vorkreisfilter 12 ist mit seinem gemeinsamen Filterausgang 13 an den Eingang 14 eines gemeinsamen Vorverstärkers 15 angeschaltet. Der Ausgang 16 des Vorverstärkers 15 liegt an einer zweistufigen Umschalteinrichtung 17, an deren Ausgänge einerseits der Eingang 18 eines für den tiefen Frequenzbereich bemessenen Bandfilters 19 und an dessen anderen Ausgang der Eingang 20 eines für den hohen Frequenzbereich bemessenen Bandfilters 21 angeschlossen ist. Die Umschaltung des Vorkreisfilters und der Umschalteinrichtung 17 erfolgt jeweils gleichzeitig über eine strichpunktiert angedeutete Schaltverbindung 22 abhängig vom ausgewählten Frequenzbereich. Die Ausgänge 23 bzw. 24 der Bandfilter 19 bzw. 21 sind jeweils auf eine eigenständige Mischstufe 25 bzw. 26 geschaltet. Auch den Mischstufen 25 und 26 ist je ein eigener Oszillator 27 bzw. 28 zugeordnet. Ferner sind die Mischstufen 25 und 26 unabhängig voneinander an den gemeinsamen Zwischenfrequenzkreis 9 angeschlossen. Die Mischstufen und Oszillatoren sind Teil einer integrierten Tunerschaltung 29, beispielsweise vom Typ TDA 5330 T oder TUA 2007. Die getrennten Bandfilter 19 bzw. 21 ermöglichen dabei eine sehr hohe Empfangsempfindlichkeit bei großer Störsicherheit, weil sie optimal für den entsprechenden Frequenzbereich bemessen sein können und keine die Selektion beeinflussenden Schaltdioden erfordern. Es sind daher auch keine gesonderten Umschaltspannungen für die Schaltdioden erforderlich. Zur hohen Selektion und Störsicherheit trägt auch die jeweils eigenständig Mischstufe bei, so daß übliche Kompromisse für die Mischstufenbeschaltung entfallen.

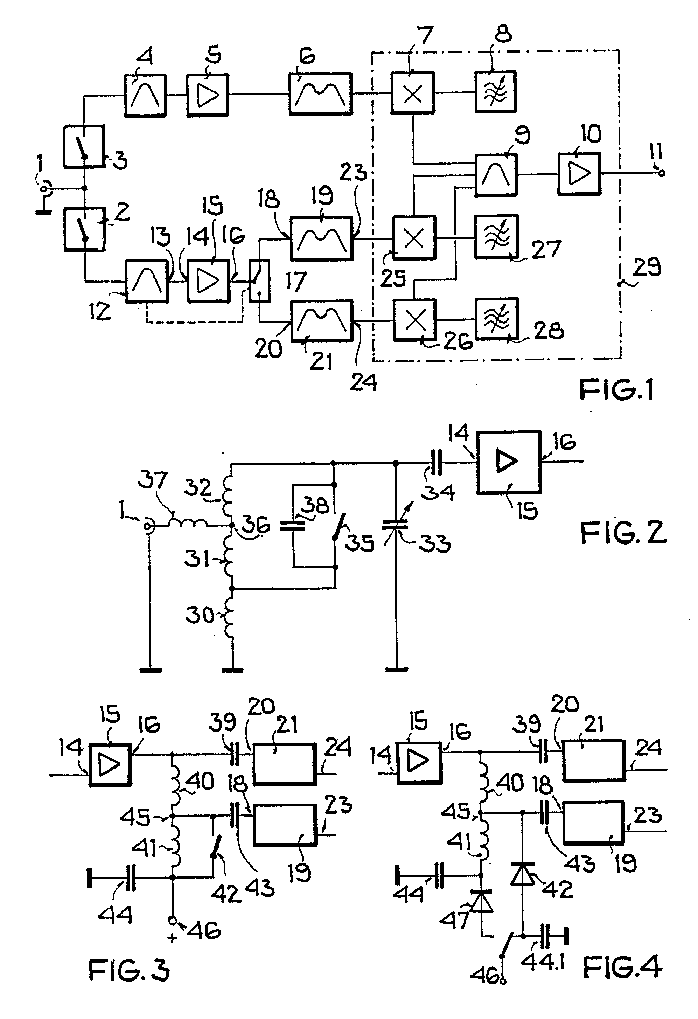

Die Vorkreis- und Vorverstärkerschaltung ist ohne Berücksichtigung des ersten Bereichsschalters 2 in Figur 2 dargestellt. Das Vorkreisfilter besteht demnach aus der Serienschaltung von drei frequenzbestimmenden Spulen 30, 31, 32 zu welchen ein gemeinsamer frequenzbestimmender Kondensator 33 vorzugsweise in Form einer spannungssteuerbaren Kapazitätsdiode parallel geschaltet ist.

Die erste Spule 30 ist dabei einseitig an Massepotential und die dritte Spule 32 über einen Trennkondensator 34 an den Eingang 14 des Vorverstärkers 15 angeschlossen. Parallel zur Serienschaltung aus der zweiten und der dritten Spule 31 bzw. 32 liegt dagegen ein Bereichschalter 35, der insbesondere als gleichstrommäßig steuerbare Schaltdiode ausgebildet ist. Vom Verbindungspunkt 36 zwischen der zweiten und der dritten Spule 31 bzw. 32 führt eine Anpassungsspule 37 zum Antennenanschluß 1. In der dargestellten Schaltstellung gemäß Figur 2 ist das Vorkreisfilter 12 für den niedrigen Frequenzbereich bemessen, der von zirka 50 bis 150 MHz reicht. Innerhalb dieses Frequenzbereichs ist die Anpassungsspule 37 besonders bei den niedrigen Frequenzen weitgehend ohne Wirkung. Die Anpassung erfolgt hier durch das Teilungsverhältnis der Induktivitätswerte der Spulen 30, 31 und 32. Durch die Kapazitätsvariation des Kondensators 33 läßt sich so der niedrige Frequenzbereich durchstimmen, in dem alle drei Spulen 30, 31 und 32 frequenzbestimmend sind. Da der Frequenzvariationsbereich im niedrigen Frequenzbereich etwas kleiner ist als im hohen Frequenzbereich, der von zirka 150 bis 470 MHz reicht, kann parallel zum Bereichschalter 35 ein Korrekturkondensator 38 geschaltet werden, der den wirksamen Variationsbereich des Kondensators 33 bei geöffnetem Bereichsschalter (35) im erforderlichen Maß begrenzt. Der Bereichschalter (35) dient so gleichzeitig zur Änderung des Durchstimmverhältnisses.

Wird der Bereichschalter 35 geschlossen, ist allein die Spule 30 unmittelbar parallel zum Kondensator 33 geschaltet und bestimmt so den hohen Frequenzbereich. Bei geschlossenem Bereichschalter 35 ist auch der Korrekturkondensator 38 kurzgeschlossen und damit der Kondensator 33 mit seinem gesamten Variationsbereich allein frequenzbestimmend. Zusätzlich wird bei geschlossenem Bereichschalter 35 auch die Serienschaltung aus den Spulen 31 und 32 zu einer Parallelschaltung, die in Serie mit der Anpassungsspule 37 liegt. Die Spulen 31, 32 und 37 dienen dann gemeinsam der Anpassung des Vorkreisfilterkreises an den Wellenwiderstand der Antennenleitung, wobei dann für den Abgleich der Anpassung die Anpassungsspule 37 in ihrem Induktivitätswert verändert werden kann. Diese Änderung wirkt sich im niedrigeren Frequenzbereich praktisch nicht aus. Auch beeinflußt eine für den Abgleich des Schwingkreises gegebenenfalls vorzunehmende Änderung des Induktivitätswerts der Spule 30 die Schwingfrequenz des gesamten Schwingkreises im niedrigeren Frequenzbereich nur unerheblich, weil der Induktivitätswert der Spule 30 im Vergleich zum Gesamtinduktivitätswert der Spulen 31 und 32 klein ist. Diese Vorkreisschaltung erfordert auch nur einen gemeinsamen Vorverstärker 15, so daß mit nur einem Bereichschalter 35 eine Frequenzbereichumschaltung, eine Änderung des Abstimmverhältnisses und eine Umschaltung der Anpassung in den Frequenzbereichen erfolgt. Für diese minimale Zahl an Bauteilen ist somit auch nur ein entsprechend kleiner Raum im Tunergehäuse erforderlich, ohne die Selektion und Störsicherheit nachteilig zu beeinflussen.

An den Ausgang 16 des Vorverstärkers 15 ist die Umschalteinrichtung 17 für die Bandfilter 19 bzw. 21 angeschlossen, wobei die Umschalteinrichtung einen Kondensator 39 aufweist, der vom Ausgang 16 an den Eingang 20 des Bandfilters 21 für den hohen Frequenzbereich geschaltet ist. Eine Spule 40 führt vom Ausgang 16 über die Parallelschaltung aus einer Hochfrequenzdrossel 41 sowie einem Bandschalter 42 zu einer Stromversorgungsquelle 43 bzw. über einen Kondensator 43 zum Eingang 18 des Bandfilters 19 für den tiefen Frequenzbereich. Der Bandschalter 42 ist wie die Hochfrequenzdrossel 41 über einen Abblockkondensator 44 bzw. 44.1 hochfrequenzmäßig an Massepotential angeschaltet. Bei geschlossenem Bandschalter 42, der vorzugsweise ebenfalls eine Schaltdiode ist und zusammmen mit dem Bereichsschalter 35 gesteuert wird, bildet der Kondensator 39 mit der Spule 40 einen Hochpaß für den hohen Frequenzbereich, indem der Verbindungspunkt 45 der Spule 40 mit dem Kondensator 43 über den Bandschalter 42 hochfrechquenzmäßig an Massepotential angeschlossen ist. Das Bandfilter für den tiefen Frequenzbereich ist somit hochfrequenzmäßig eingangsseitig kurzgeschlossen. Das Hochpaßfilter 39, 40, 42, 47 ermöglicht somit eine optimale Anpassung zwischen dem Vorverstärker 15 und dem Bandfilter 21.

Bei nicht leitendem, also offenem Bandschalter 42 bildet dagegen die Spule 40 mit dem Kondensator 43 sowie der kapazitiven Eingangsimpedanz des Bandfilters 21 einen Tiefpaß für den tiefen Frequenzbereich, wobei das angeschaltete Bandfilter 19 das noch über den Kondensator 39 angekoppelte Bandfilter 21 für den hohen Frequenzbereich so weitgehend verstimmt, daß auch dort eine Selektion bestimmter Frequenzen nicht mehr möglich ist.

Durch die Hochfrequenzdrossel 41 ist bei geöffnetem Bandschalter 42 ein Gleichstromweg zum Ausgang 16 des Verstärkers 15 gegeben, so daß über diesen Weg das im Vorverstärker 15 vorhandene Verstärkerelement mit Gleichstrom versorgt werden kann, ohne den Tiefpaß zu beeinflussen.

In Figur 4 ist eine Schaltungsanordnung gemäß Figur 3 dargestellt, bei der als Bandschalter eine Schaltdiode 42 verwendet ist. Dort ist bei sonst gleichem Schaltungsaufbau in Serie mit der Hochfrequenzdrossel eine einfache Diode 47 vorgese

hen, über welche die Gleichstromspeisung des Vorverstärkers 15 erfolgt, wenn der niedrige Frequenzbereich eingeschaltet sein soll. In diesem Falle ist die Schaltdiode 42 stromlos und damit gesperrt, der Bereichschalter also offen. Wird dagegen die Schaltdiode 42 an die Gleichstromquelle 46 angeschaltet, dann bewirkt der sie durchfließende Strom das Durchschalten, wodurch der Bandschalter geschlossen ist. Die Schaltungsanordnung ist dann für den hohen Frequenzbereich umgeschaltet, nachdem dann der Verbindungspunkt 45 über die Schaltdiode 42 und den zugeordneten Abblockkondensator 44.1 an Massepotential liegt. Bei der Umschalteinrichtung 17 liegt die Schaltdiode 42 bzw. der Bandschalter nicht in einem frequenzbestimmenden Schwingkreis, so daß die Selektion nachteilig beeinflussende Wirkungen nicht auftreten.

Der Vorteil der Erfindung liegt darin, daß die Empfindlichkeit bzw. die Störsicherheit des Tuners gegenüber einem 2-Band VHF-Tuner verbessert wird, so daß entsprechende Eigenschaften mit erheblich weniger Aufwand erreicht werden.

## Ansprüche

1. Fernsehtuner mit einem gemeinsamen Antennenanschluß für zwei Frequenzbereiche, die die Frequenzen von VHF-Band I bis einschließlich Hyperband überstreichen, mit einer für die beiden Frequenzbereiche bemessenen Vorkreisfilter- und Vorverstärkerschaltung sowie mit zwei eigenständigen, für einen niedrigen bzw. einen hohen Frequenzbereich bemessenen Bandfilter sowie einer nachfolgenden Mischstufen- und Zwischenfrequenzschaltung, dadurch gekennzeichnet, daß eine Schwingkreisschaltung mit umschaltbaren Spulen ein für beide Frequenzbereiche kombiniertes Vorkreisfilter (12) bildet, dessen Ausgang an einen Eingang (14) eines Vorverstärkers (15) angeschaltet ist daß der Ausgang des Vorverstärkers (15) an eine zweistufige Umschalteinrichtung (17) gelegt ist, die gleichzeitig mit dem Vorkreisfilter (15) umgeschaltet wird und an die getrennt die Bandfilter (19,21) angeschlossen sind und daß die Ausgänge der Bandfilter (19,21) je an eine eigene Mischstufe (25,26) angeschlossen sind.

2. Fernsehtuner nach Anspruch 1, dadurch gekennzeichnet, daß das Vorkreisfilter (12) eine Serienschaltung von drei frequenzbestimmenden Spulen (30,31,32) aufweist, zu welchen ein gemeinsamer frequenzbestimmender Kondensator (33) parallel geschaltet ist, daß die erste Spule (30) an Massepotential und die dritte Spule (32) an den Eingang (14) des Vorverstärkers (15) angeschlossen ist, daß parallel zur Serienschaltung aus der zweiten und der dritten Spule (31 bzw. 32) ein Bereichschalter (35) liegt, daß an den Verbindungspunkt (36) zwischen der zweiten und der dritten Spule (31 bzw. 32) eine Anpassungsspule (37) angeschaltet ist, die andererseits mit dem Antennenanschluß (1) verbunden ist und daß die erste Spule (30) frequenzbestimmend für den hohen Frequenzbereich ist.

3. Fernsehtuner nach Anspruch 1 oder 2, dadurch gekennzeichnet, daß das Vorkreisfilter (12) abstimmbar ist.

4. Fernsehtuner nach Anspruch 2 oder 3, dadurch gekennzeichnet, daß die Anpassungsspule (37) für den hohen Frequenzbereich bemessen ist.

5. Fernsehtuner nach Anspruch 2 oder einem der folgenden, dadurch gekennzeichnet, daß parallel zum Bereichschalter (35) ein Korrekturkondensator (38) liegt.

6. Fernsehtuner nach Anspruch 1 oder einem der folgenden, dadurch gekennzeichnet, daß an den Ausgang (16) des Vorverstärkers (15) einerseits ein Bandfilter (21) für den hohen Frequenzbereich über einen Hochpaß, gebildet durch den Kondensator (39) und die Spule (40), und andererseits ein Bandfilter (19) für den tiefen Frequenzbereich über eine Tiefpaßschaltung aus einer Spule (40) und einem Kondensator gebildet durch die Diodenkapazität (42) und den Kondensator (47) angeschaltet ist und daß zwischen dem Verbindungspunkt (45) der Spule (40) mit dem Kondensator (43) und Massepotential ein Bandschalter (42) liegt.

7. Fernsehtuner nach Anspruch 6, dadurch gekennzeichnet, daß bei geschlossenem Bandschalter (42) der Kondensator (39) mit der Spule (40) einen Hochpaß für den hohen Frequenzbereich bildet und das Bandfilter (19) für den niedrigen Frequenzbereich eingangsseitig kurzgeschlossen ist.

8. Fernsehtuner nach Anspruch 6 oder 7 , dadurch gekennzeichnet, daß bei nichtleitendem Bandschalter (42) die Spule (40) mit dem Kondensator, gebildet durch den Kondensator (39) und die Spule (40), einen Tiefpaß für den tiefen Frequenzbereich bildet und das Bandfilter (21) für den hohen Frequenzbereich verstimmt ist.

9. Fernsehtuner nach Anspruch 6,7 oder 8, dadurch gekennzeichnet, daß parallel zum Bandschalter (42) eine Hochfrequenzdrossel (41) liegt, die einerseits an eine Gleichstromquelle (46) angeschlossen ist und daß der Ausgang (16) des Vorverstärkers (15) gleichstrommäßig mit dem aktiven Verstärkerelement verbunden ist.

10. Fernsehtuner nach Anspruch 6,7 oder 8, dadurch gekennzeichnet, daß der Verbindungspunkt (45) der Spule (40) mit dem Kondensator (43) einerseits über den Bandschalter (42) und einen Abblockkondensator (44.1) hochfrequenzmäßig an Massepotential und gleichstrommäßig über einen Schaltkontakt an eine Spannungsquelle (46) und andererseits über die Serienschaltung aus einer Hochfrequenzdrossel (41), einer Diode (47) und einer weiteren Schaltstrecke an eine Spannungsquelle (46) anschaltbar ist.

11. Fernsehtuner nach Anspruch 1 oder einem der folgenden, dadurch gekennzeichnet, daß zwischen den Antennenanschluß (1) und das Vorkreisfilter (12) ein erster Bereichsschalter (2) gelegt ist, daß an den Antennenanschluß (1) ein zweiter Bereichsschalter (3) angeschlossen ist, der einem UHF-Tunerzweig vorgeschaltet ist und daß der Ausgang der Mischstufe (7) des UHF-Tunerzweiges zusammen mit den Ausgängen der anderen Mischstufen (25,26) an einen Zwischenfrequenz-Selektor (9) angeschlossen ist, der einen gemeinsamen Zwischenfrequenzausgang (11) aufweist.

FIG.1

FIG.2

FIG.3

FIG.4